# EUROPÄISCHE PATENTSCHRIFT

(11) **EP 0 711 363 B1**
(45) Veröffentlichungstag und Bekanntmachung des Hinweises auf die Patenterteilung: **03.02.1999**
(21) Anmeldenummer: 94921662.6
(22) Anmeldetag: 21.07.1994
(51) Int. Cl.: H01L 29/38, H01L 21/322, C30B 23/00

(54) **HOCHOHMIGES SILIZIUMKARBID UND VERFAHREN ZU DESSEN HERSTELLUNG**
HIGH RESISTANCE SILICON CARBIDE AND PROCESS FOR PRODUCTION THEREOF
CARBURE DE SILICIUM A RESISTANCE ELEVEE ET SON PROCEDE DE FABRICATION

(30) Priorität: 31.07.1993 DE 4325804
(43) Veröffentlichungstag der Anmeldung: 15.05.1996
(73) Patentinhaber: DAIMLER-BENZ AKTIENGESELLSCHAFT, 70547 Stuttgart (DE); FRAUNHOFER-GESELLSCHAFT ZUR FÖRDERUNG DER ANGEWANDTEN FORSCHUNG E.V., 80636 München (DE)
(72) Erfinder: NIEMANN, Ekkehard, D-63447 Maintal (DE); SCHNEIDER, Jürgen, D-79199 Kirchzarten (DE); MÜLLER, Harald, D-79856 Hinterzarten (DE); MAIER, Karin, D-79102 Freiburg (DE)
(74) Vertreter: Fröhling, Werner Otto, Dr.
(86) Internationale Anmeldenummer: EP9402400
(87) Internationale Veröffentlichungsnummer: WO9504171

(56) Entgegenhaltungen:
- WO-A-89/06438
- DE-A- 4 009 837
- 7TH TRIESTE SEMICONDUCTOR SYMPOSIUM ON WIDE-BAND-GAP SEMICONDUCTORS, TRIESTE, ITALY, 8-12 JUNE 1992, ISSN 0921-4526, PHYSICA B, APRIL 1993, NETHERLANDS, PAGE(S) 199 - 206 SCHNEIDER J ET AL 'Point defects in silicon carbide'
- JOURNAL OF APPLIED PHYSICS, OCT. 1976, USA, VOL. 47, NR. 10, PAGE(S) 4546 - 4550, ISSN 0021-8979 SUZUKI A ET AL 'Liquid-phase epitaxial growth of 6H-SiC by the dipping technique for preparation of blue-light-emitting diodes'
- APPLIED PHYSICS LETTERS, 19 MARCH 1990, USA, VOL. 56, NR. 12, PAGE(S) 1184 - 1186, ISSN 0003-6951 SCHNEIDER J ET AL 'Infrared spectra and electron spin resonance of vanadium deep level impurities in silicon carbide' in der Anmeldung erwähnt
- 17TH INTERNATIONAL CONFERENCE ON DEFECTS IN SEMICONDUCTORS, GMUNDEN, AUSTRIA, 18-23 JULY 1993, ISSN 0255-5476, MATERIALS SCIENCE FORUM, 1994, SWITZERLAND, PAGE(S) 75 - 79 REINKE J ET AL 'Magnetic circular dichroism and optically detected EPR of a vanadium impurity in 6H-silicon carbide'
- PROCEEDINGS OF THE IEEE, MAY 1991, USA, VOL. 79, NR. 5, PAGE(S) 677 - 701, ISSN 0018-9219 DAVIS R F ET AL 'Thin film deposition and microelectronic and optoelectronic device fabrication and characterization in monocrystalline alpha and beta silicon carbide'
- SOVIET PHYSICS SEMICONDUCTORS, Bd.21, Nr.9, September 1987, NEW YORK US Seiten 1017 - 1020 YU. A. VODAKOV ET AL 'Electrical properties of a p-n-n+ structure formed in silicon carbide by implantation of aluminum ions'

## Beschreibung

Die Erfindung betrifft ein Verfahren zum Herstellen von hochohmigem SiC nach dem Oberbegriff des Anspruchs 1.

SiC in kristalliner Form besitzt Eigenschaften eines halbleitenden Materials und wird zunehmend in verschiedenen Halbleiterbauelementen angewendet. Es ist für viele Anwendungen wünschenswert, daß das Substrat, d. h. der Ausgangskristall, eine Scheibe aus einem hochohmigen Material ist. Diese Einkristallscheibe kann dann als gemeinsames Substrat für eine Mehrzahl individueller Bauelemente dienen, welche alle elektrisch isoliert sind. Viele Prozesse, welche beispielsweise mit reinem Si durchgeführt wurden, sind auf SiC übertragbar, d. h. im einzelnen Maskentechnik mit einem thermischen Oxid, Ionenimplantation, Trockenätzen von Strukturen, epitaxiales Aufwachsen und Kontaktieren.

Das Verständnis von Defekten mit tiefen Niveaus in der Bandlücke von SiC ist noch sehr unvollkommen. Beispielsweise ist sehr wenig bekannt über Übergangsmetalle in SiC, sowohl hinsichtlich ihrer Defektstruktur (substitutionell oder interstitiell) als auch ihrer vermuteten elektrischen Aktivität als Störstellen mit energetisch weit unter dem Leitfähigkeitsband liegenden Zuständen. Ein wichtiges Merkmal von SiC ist seine Polytypie, d. h. sein Vorkommen in mehreren Modifikationen. Für elektronische Anwendungen interessant sind das hexagonale 4H- und 6H-SiC mit einer Bandlücke von 3,0 eV und das kubische 3C-SiC mit einer Bandlücke von 2,4 eV. Sehr wenig ist insbesondere über die Niveaulage von Titan-Verunreinigungen bekannt, welche bei tiegelgezogenem SiC praktisch unvermeidbar sind. Die Kenntnis und Kontrolle von Verunreinigungen mit tiefen Energieniveaus sind aber unbedingt erforderlich, um die Qualität von optoelektronischen und elektronischen Bauelementen auf der Basis von SiC zu gewährleisten.

Aus der Veröffentlichung: J. Schneider, H.D. Müller, K. Maier, W. Wilkening, F. Fuchs, A. Dörnen, S. Leibenzeder und R. Stein, Appl. Phys. Lett., 56 (1990) S. 1184, ist bekannt, daß Vanadiumverunreinigungen in SiC-Kristallen als amphoterische Verunreinigung mit energetisch tiefen Niveaus auftreten können. Das bedeutet, daß zumindest drei verschiedene Ladungszustände des Vanadiums in SiC auftreten. Es werden mit Vanadium zwei neue Niveaus in der Bandlücke erzeugt. Aufgrund dessen wurde vermutet, daß Vanadium in SiC die Lebensdauer von Minoritätsträgern herabsetzen kann. Auch in einer späteren Veröffentlichung: K. Maier, J. Schneider, W. Wilkening, S. Leibenzeder und R. Stein, "Electron spin resonance studies of transition metal deep level impurities in SiC, Materials Sience and Engineering B11" (1992) S. 27 - 30, werden diese Niveaus untersucht. Auch sie enthält keine Hinweise darauf, wie man Verunreinigungen gezielt in p-dotiertes 4H- und 6H-SiC einbringen kann, um diese elektrisch zu kompensieren und hochohmiges SiC herzustellen.

Aus der Patentschrift US 3,344,071 ist bekannt, wie man aus GaAs-Kristallen, die aus der Schmelze gezogenen sind, durch gezieltes Dotieren mit Chrom hochohmiges Material herstellen kann. Im n-Typ GaAs muß zusätzlich eine als Akzeptor wirkende Substanz zugesetzt werden.

Bisher ist nicht bekannt, wie man im Falle von SiC die Wirkung flacher Störstellen aufheben und hochohmiges Material erzeugen kann.

Der Erfindung liegt die Aufgabe zugrunde, SiC mit hohem Widerstand zu schaffen, wobei der Einfluß von Verunreinigungen kompensiert werden soll.

Gelöst wird diese Aufgabe mit den im kennzeichnenden Teil der Ansprüche 1 und 11 angegebenen Merkmalen.

Der Gegenstand des Anspruchs 1 und 11 weist die Vorteile auf, daß ein Material wie SiC, welches für hohe Temperaturen anwendbar ist, auch genügend hochohmig hergestellt werden kann. Damit können dann laterale Bauelemente aus SiC auf isolierendem SiC Substrat hergestellt werden. Diese Bauelemente können dann auch bei höheren Umgebungstemperaturen eingesetzt werden.

Die Schwierigkeit, ein hochohmiges Material mit SiC zu erzeugen, liegt darin, daß bei der herkömmlichen Sublimationsmethode nach Lely sehr viel Stickstoff als Verunreinigung in das hexagonale Gitter eingebaut wird. Dieser Stickstoff besitzt flache Donatorniveaus, welche die Leitfähigkeit des Materials durch Elektronenabgabe in das Leitungsband sehr stark erhöhen. Da Vanadium im SiC ebenfalls ein Donatorniveau besitzt, kann es nicht zur Kompensation der flachen Haftstellen benutzt werden. Aus diesem Grunde wird hier vorgeschlagen, die tiefen Haftstellen des Vanadiums trotzdem auszunutzen, da sie fast in der Mitte der Bandlücke des hexagonalen SiC liegen. Zunächst werden deshalb die Donatorniveaus des Stickstoffs durch eine Aluminiumdotierung leicht überkompensiert. Die Konzentration des dreiwertigen Dotierstoffs wird 2 - 30 % höher gewählt als die Konzentration an fünfwertigen Verunreinigungen beträgt. Die dann elektrisch aktiven flachen Akzeptorniveaus des Aluminiums können schließlich durch die tiefen Donatorniveaus des Vanadiums vollständig kompensiert werden. Die Konzentration des Übergangselements wird dazu vorzugsweise mindestens um den Faktor 2 höher gewählt als die Differenz der Konzentrationen der drei- und fünfwertigen Fremdatome. Für die Leitfähigkeit spielt eine Überkompensation von Vanadium wiederum keine Rolle, da die Niveaus so tief liegen, daß sie thermisch nicht aktiviert werden können.

In einem bevorzugten Ausführungsbeispiel der Erfindung wird eine Scheibe aus einkristallinem 6H-SiC mit einer Resthintergrunddotierung mit Stickstoff von 5 · 10¹⁶ / ccm verwendet. Die p-Dotierung wird mit Aluminium mit einer Konzentration von 1 · 10¹⁷ / ccm durchgeführt. Die Vanadiumdotierung beträgt 2 · 10¹⁷ /ccm. Unabhängig von der Art der Einbringung der Dotierung beträgt der spezifische Widerstand wenigstens 10⁸ Ohm · cm bei 300 °K.

Man wird es erfindungsgemäß natürlich so einrichten, daß nur ein kleiner Anteil elektrisch aktiver Verunreinigungen vorhanden ist, wobei Verunreinigungen mit Donatoreigenschaften vorherrschen. Bei der Einführung von Übergangselementen wird mit einer Dotierstoffmenge gearbeitet, die die Gesamtmenge aller elektrisch aktiven Verunreinigungen übersteigt.

In einem weiteren Ausführungsbeispiel der Erfindung wird die Dotierung vor der Herstellung eines Einkristalls durchgeführt. Das einkristalline SiC wird dazu nach dem Sublimationsverfahren von Lely hergestellt. Der verwendete vielkristalline Ausgangskristall enthält vorzugsweise metallisches Vanadium und Aluminium. Die dreiwertigen Dotierstoffe und Übergangselemente werden also am Anfang des Produktionsprozesses zusammen zugegeben. In einer Abwandlung des Verfahrens wird metallisches Vanadium und Aluminium separat verdampft. Das legt es nahe, daß die Dotierstoffe nacheinander zugegeben werden, wobei es zweckmäßig ist, daß vor der Zugabe des letzten Dotierstoffs eine Bestimmung der Ladungsträgerkonzentration durchgeführt wird. Auch hierbei wird das Herstellen des Einkristalls durch Sublimation eines weniger perfekten Kristalls vorgenommen, wobei gleichzeitig die Dotierstoffe in der Dampfphase erzeugt und auf dem Substrat des SiC-Einkristalls niedergeschlagen werden, und diese elektrisch aktiven Dotierstoffe eine größere Konzentration aufweisen als die durch den Sublimationsprozeß eingeführten Verunreinigungen.

In einem weiteren für die Erfindung wichtigen Verfahren wird auf ein SiC-Substrat mittels Epitaxie eine weitere einkristalline SiC-Schicht (3C-SiC) abgeschieden. Vanadium wird mit Hilfe von Vanadiumchlorid oder einer metallorganischen Verbindung durch CVD-Verfahren aufgebracht. Die Dotierung mit Vanadium beträgt wie im ersten Beispiel 2 · 10¹⁷ /ccm.

Dadurch entsteht eine dünne hochohmige Schicht von SiC. In einem weiteren bevorzugten Verfahren werden dünne Schichten auch durch Ionenimplantation von Vanadium und Aluminium hochohmig gemacht.

Auch als Kapselung von SiC-Bauelementen ist das hochohmige Material geeignet. Die Substratscheibe ist als Grundplatte für das sogenannte Packaging von Bauelementen ohne weiteres geeignet. Das gleiche gilt für die Kontaktierung, wobei die Substratscheibe einen mechanisch stabilen Kontaktträger darstellt.

Das Verfahren ist auch auf kubisches 3C-SiC übertragbar. Diese Struktur ist bei epitaxialem Wachstum bevorzugt. Stickstoff als Verunreinigung beim Wachstum der Schichten führt auch hier zur P-Leitfähigkeit, die mit dieser Methode wirksam unterdrückt wird. Legt man das Donatorniveau des Vanadiums von 6H-SiC zugrunde und berücksichtigt die Verhältnisse der Bandlücken, so kann man abschätzen, daß das Donatorniveau des Vanadiumatoms in 3C-SiC bei Ev = 1,7 eV liegt. Dieser Wert übersteigt die ideale Bandmitte nur um 0,5 eV. Daher führt eine Dotierung mit Vanadium auch in diesem Falle zu epitaxialen 3C-SiC-Schichten, welche einen hohen spezifischen Widerstand besitzen.

## Patentansprüche

1. Verfahren zum Herstellen von hochohmigem SiC aus einem niederohmigen Ausgangsmaterial,
**dadurch gekennzeichnet,**
daß die flachen Donatorniveaus einer vorherrschenden Stickstoff-Verunreinigung durch Zugabe eines dreiwertigen Elements mit flachen Akzeptorniveaus überkompensiert werden, in dem diese Dotierung mit einer Konzentration in das SiC eingebaut wird, welche den Leitungstyp von n- auf p-Leitung ändert, und daß weiter ein Übergangselement, welches in SiC etwa in der Mitte von dessen Bandlücke Donatorniveaus aufweist, zugegeben wird, womit die überzähligen Akzeptorniveaus wiederum kompensiert werden, so daß ein hoher spezifischer Widerstand erzielt wird.

2. Verfahren nach Anspruch 1,
dadurch gekennzeichnet,
daß als Dotierstoff mit flachen Akzeptorniveaus ein Element aus der dritten Hauptgruppe verwendet wird.

3. Verfahren nach Anspruch 1 oder 2,
dadurch gekennzeichnet,
daß als Dotierstoff mit flachen Akzeptorniveaus das Element Aluminium (Al) verwendet wird.

4. Verfahren nach einem der Ansprüche 1 bis 3,
dadurch gekennzeichnet,
daß als Übergangselement Vanadium (V) verwendet wird.

5. Verfahren nach einem der Ansprüche 1 bis 4,
dadurch gekennzeichnet,
daß die Konzentration des dreiwertigen Dotierstoffs 2 - 30 % höher gewählt wird als die Konzentration an fünfwertigen Verunreinigungen beträgt.

6. Verfahren nach einem der Ansprüche 1 bis 5,
dadurch gekennzeichnet,
daß die Konzentration des Übergangselements mindestens um den Faktor 2 höher gewählt wird als die Differenz der Konzentrationen der drei- und fünfwertigen Dotierstoffe.

7. Verfahren nach einem der Ansprüche 1 bis 6,
dadurch gekennzeichnet,
daß die dreiwertigen Dotierstoffe und Übergangselemente am Anfang des Produktionsprozesses zusammen zugegeben werden.

8. Verfahren nach einem der Ansprüche 1 bis 6,
dadurch gekennzeichnet,
daß die Dotierstoffe nacheinander zugegeben werden, wobei vor der Zugabe des letzten Dotierstoffs eine Bestimmung der Ladungsträgerkonzentration durchgeführt wird.

9. Verfahren nach einem der Ansprüche 1 bis 8,
dadurch gekennzeichnet,
daß ein kleiner Anteil elektrisch aktiver Verunreinigungen vorhanden ist, wobei Verunreinigungen mit Donatoreigenschaften vorherrschen, daß die Stufe der Einführung von Übergangselementen mit einer Menge, die die Gesamtmenge aller elektrisch aktiven Verunreinigungen übersteigt, vor der Herstellung eines Einkristalls durchgeführt wird.

10. Verfahren nach einem der Ansprüche 1 bis 9,
dadurch gekennzeichnet,
daß das Herstellen des Einkristalls durch Sublimation eines weniger perfekten Kristalls vorgenommen wird, wobei gleichzeitig die Dotierstoffe in der Dampfphase erzeugt und auf dem Substrat des SiC-Einkristalls niedergeschlagen werden, und diese elektrisch aktiven Dotierstoffe eine größere Konzentration aufweisen als die durch den Sublimationsprozeß eingeführten Verunreinigungen.

11. SiC-Kristall, welcher eine elektrisch aktive Verunreinigung überwiegend aus Stickstoff aufweist, dessen Konzentration etwa 5 · 10¹⁶ Atome/ccm beträgt, wobei dieses Material einen spezifischen Widerstand von wenigstens 10⁸ Ohm · cm bei 300 °K aufweist,
dadurch gekennzeichnet,
daß durch Zugabe eines dreiwertigen Elements mit flachen Akzeptorniveaus die flachen Donatorniveaus einer vorherrschenden Stickstoff-Verunreinigung überkompensiert sind, indem diese Dotierung mit einer solchen Konzentration in das SiC eingebaut ist, daß der Leitungstyp von n- auf p-Leitung geändert ist, und daß ein Übergangselement, welches in SiC etwa in der Mitte von dessen Bandlücke Donatorniveaus aufweist, vorhanden ist, womit die überzählichen Akzeptorniveaus wiederum kompensiert sind, so daß ein hoher spezifischer Widerstand erzielt ist.

12. SiC-Kristall nach Anspruch 11, oder Verfahren nach einem der Ansprüche 1 bis 10,
dadurch gekennzeichnet,
daß der Si-C Kristall hexagonale Kristallstruktur besitzt.

13. SiC-Kristall nach Anspruch 11 oder 12, oder Verfahren nach einem der Ansprüche 1 bis 10,
dadurch gekennzeichnet,
daß der Si-C Kristall kubische Kristallstruktur besitzt.

## Claims

1. Method of producing high-resistance SiC from a low-resistance starting material, characterised thereby that the flat donor levels of a prevailing nitrogen impurity are overcompensated by addition of a trivalent element with flat acceptor levels, in that this doping is incorporated in the SiC with a concentration which changes the conductivity type from n-conductivity to p-conductivity, and that further a transition element, which has donor levels in SiC approximately in the middle of the energy-gap thereof, is added, whereby the excess acceptor levels are in turn compensated so that a high specific resistance is achieved.

2. Method according to claim 1, characterised thereby that an element from the third primary group is used as doping material with flat acceptor levels.

3. Method according to claim 1 or 2, characterised thereby that the element aluminium (Al) is used as doping material with flat acceptor levels.

4. Method according to one of claims 1 to 3, characterised thereby that vanadium (V) is used as transition element.

5. Method according to one of claims 1 to 4, characterised thereby that the concentration of the trivalent doping material is selected to be 2 to 30% higher than the concentration of pentavalent impurities amounts to.

6. Method according to one of claims 1 to 5, characterised thereby that the concentration of the transition element is selected to be higher by at least the factor 2 than the difference of the concentrations of the trivalent and pentavalent doping materials.

7. Method according to one of claims 1 to 6, characterised thereby that the trivalent doping materials and transition elements are added together at the start of the production process.

8. Method according to one of claims 1 to 6, characterised thereby that the doping materials are added in succession, wherein a determination of the charge concentration is carried out before the addition of the last doping material.

9. Method according to one of claims 1 to 8, characterised thereby that a small proportion of electrically active impurities is present, wherein impurities with donor properties prevail, and that the step of introduction of transition elements is carried out with a quantity, which exceeds the total quantity of all electrically active impurities, before the production of a monocrystal.

10. Method according to one of claims 1 to 9, characterised thereby that the production of the monocrystal is undertaken by sublimation of a less perfect crystal, wherein at the same time the doping materials are produced in the vapour phase and precipitated on the substrate of the SiC monocrystal, and these electrically active doping substances have a greater concentration than the impurities introduced by the sublimation process.

11. SiC crystal which has an electrically active impurity predominantly of nitrogen, the concentration of which amounts to about 5 · 10¹⁶ atoms/ccm, wherein this material has a specific resistance of at least 10⁸ ohm · cm at 300° K, characterised thereby that through addition of a trivalent element with flat acceptor levels the flat donor levels of a prevailing nitrogen impurity are over-compensated, in that this doping is incorporated in the SiC with such a concentration that the conductivity type is changed from n-conductivity to p-conductivity and that a transfer element, which has donor levels in SiC approximately in the middle of the energy-gap thereof, is present, whereby the excess acceptor levels are in turn compensated so that a high specific resistance is achieved.

12. SiC crystal according to claim 11 or method according to one of claims 1 to 10, characterised thereby that the SiC crystal has a hexagonal crystal structure.

13. SiC crystal according to claim 11 or 12 or method according to one of claims 1 to 10, characterised thereby that the SiC crystal has a cubic crystal structure.

## Revendications

1. Procédé pour la production de SiC de forte résistance à partir d'un matériau de départ de faible résistance,
caractérisé en ce
que le niveau plat de donneurs d'une impureté prédominante d'azote est excessivement compensé par addition d'un élément trivalent avec niveau plat d'accepteurs, où ce dopage est incorporé dans SiC à une concentration qui modifie le type de conduction de n à p et en ce que, de plus, un élément de transition qui présente, dans SiC à peu près au milieu de son écart énergétique, un niveau de donneur est ajouté, ce qui compense le niveau d'accepteurs en nombre trop élevé et permet d'obtenir ainsi une haute résistance spécifique.

2. Procédé selon la revendication 1,
caractérisé en ce
qu'en tant qu'agent dopant avec niveau d'accepteurs plat, on utilise un élément du groupe trois.

3. Procédé selon la revendication 1 ou 2,
caractérisé en ce
qu'en tant qu'agent dopant avec niveau d'accepteurs plat, on utilise l'élément aluminium (AI).

4. Procédé selon l'une des revendications 1 à 3,
caractérisé en ce
qu'on utilise, en tant qu'élément de transition du vanadium (V).

5. Procédé selon l'une des revendications 1 à 4,
caractérisé en ce
que la concentration de l'agent dopant trivalent choisi est plus élevée de 2-30% que la concentration des impuretés tétravalentes.

6. Procédé selon l'une des revendications 1 à 5,
caractérisé en ce
que la concentration de l'élément de transition est choisie plus élevée au moins d'un facteur de deux que la différence des concentrations des agents dopants tri- et pentavalents.

7. Procédé selon l'une des revendications 1 à 6,
caractérisé en ce
que les agents dopants trivalents et les éléments de transition sont ajoutés au début du procédé de production, ensemble.

8. Procédé selon l'une des revendications 1 à 6,
caractérisé en ce
que les agents dopants sont ajoutés les uns après les autres et, avant addition du dernier agent dopant, une détermination est accomplie de la concentration en porteurs de charges.

9. Procédé selon l'une des revendications 1 à 8,
caractérisé en ce
qu'une petite proportion d'impuretés électriquement actives est présente et les impuretés ayant des propriétés de donneurs règnent, en ce que l'étape d'introduction des éléments de transition est accomplie à une quantité qui dépasse la quantité totale de toutes les impuretés électriquement actives, avant la production d'un monocristal.

10. Procédé selon l'une des revendications 1 à 9,
caractérisé en ce
que la production du monocristal est entreprise par sublimation d'un cristal moins parfait et simultanément les agents dopants sont produits en phase vapeur et déposés sur le substrat de monocristal de SiC et ces agents dopants électriquement actifs présentent une plus grande concentration que les impuretés introduites par le procédé de sublimation.

11. Cristal de SiC qui présente une impureté électriquement active principalement d'azote, dont la concentration est d'environ 5.10¹⁶ atome/cc, et ce matériau présente une résistance spécifique d'au moins 10⁸ ohm.cm à 300°K,
caractérisé en ce
que par l'addition d'un élément trivalent avec niveau plat d'accepteurs, le niveau plat de donneurs d'une impureté dominante d'azote sont excessivement compensés, de fait que ce dopage est incorporé dans SiC à une concentration telle que le type de conduction passe de la conduction de type n au type p et en ce qu'un élément de transition, qui présente un niveau de donneurs, dans SiC, à peu près au milieu de son écart énergétique est présent ce qui compense le niveau d'accepteurs en excès et permet d'obtenir une résistance spécifique élevée.

12. Cristal de SIC selon la revendication 11 ou procédé selon l'une des revendications 1 à 10,
caractérisé en ce
que le cristal de SiC est d'une structure cristalline hexagonale.

13. Cristal de SiC selon la revendication 11 ou 12 ou procédé selon les revendications 1 à 10,
caractérisé en ce
que le cristal de SiC possède une structure cristalline cubique.
